# EUROPEAN PATENT SPECIFICATION

(11) **EP 2 503 602 B1**
(45) Date of publication and mention of the grant of the patent: **29.06.2016**
(21) Application number: 10831524.3
(22) Date of filing: 15.11.2010
(51) Int. Cl.: H01L 31/075, C03C 3/085

(54) **THIN-FILM PHOTOELECTRIC CONVERSION DEVICE, AND PROCESS FOR PRODUCTION OF THIN-FILM PHOTOELECTRIC CONVERSION DEVICE**
FOTOELEKTRISCHE DÜNNSCHICHT-UMWANDLUNGSVORRICHTUNG UND VERFAHREN ZUR HERSTELLUNG DER FOTOELEKTRISCHEN DÜNNSCHICHT-UMWANDLUNGSVORRICHTUNG
DISPOSITIF DE CONVERSION PHOTOÉLECTRIQUE À COUCHE MINCE ET PROCESSUS DE PRODUCTION D'UN DISPOSITIF DE CONVERSION PHOTOÉLECTRIQUE

(30) Priority: 20.11.2009 JP 2009265271
(43) Date of publication of application: 26.09.2012
(73) Proprietor: KANEKA CORPORATION, Osaka (JP)
(72) Inventor: KIKUCHI,Takashi, Osaka-shi Osaka 530-8288 (JP); SUNAHIRO,Satoshi, Osaka-shi Osaka 530-8288 (JP)
(74) Representative: Hoffmann Eitle
(86) International application number: PCT/JP2010/070266
(87) International publication number: WO 2011/062130

(56) References cited:
- WO-A1-2008/099687
- WO-A1-2008/099687
- WO-A1-2008/149835
- WO-A1-2009/142156
- JP-A- 8 151 228
- JP-A- 2001 240 427
- JP-A- 2008 235 687

## Description

### TECHNICAL FIELD

The invention relates to a photoelectric conversion device having a stability of integration and a method for producing thereof.

### BACKGROUND ART

A thin-film photoelectric conversion device is attracting attention from the viewpoint of increasing an interest in environmental problems, reduction of costs and enhancement of efficiency. Documents JP2008 235687A and WO2008/099 687A disclose thin-film solar cells.

In a thin-film photoelectric conversion device in which light is let to be incident from the transparent base member side, it is general that a transparent electrode layer, a photoelectric conversion unit and a back electrode layer are stacked in this order from the transparent base member side; the photoelectric conversion unit is separated into a plurality of cells; and these cells are connected in series or in parallel and integrated by patterning.

Since the transparent base member used in the thin-film photoelectric conversion device is arranged on a light incident side of the photoelectric conversion unit, the transmittance thereof is preferably large from the viewpoint of improving the photoelectric conversion efficiency, and is preferably inexpensive for the purpose of suppressing the production costs. As a general transparent base member material, glass is used.

Since the transparent electrode layer is also arranged on the light incident side of the photoelectric conversion unit in the same manner as in the transparent base member, the transmittance thereof is preferably large. Further, in order to increase an effect of light incidence into the photoelectric conversion unit, it is preferable that the transparent electrode layer has surface irregularities that allow the incident light to be scattered. Also, since the transparent electrode layer functions as a conductive layer, electric loss by resistance is preferably small. Typically, a conductive metal oxide such as SnO₂ or ZnO is used, and is formed, for example, by a method such as a CVD method, a sputtering method or a vapor deposition method.

The photoelectric conversion unit is formed of semiconductor layers having a pn junction or a pin junction. An amorphous silicon layer or a crystalline silicon layer serving as a silicon-based thin film may be used as the semiconductor layer, which may be formed by low-temperature plasma-enhanced CVD method. A thin film made of CuInSe₂ (abbreviated as CIS) or CdTe may be used as the compound semiconductor thin film. Note that, in the present invention, the terms "crystalline" and "microcrystalline" also mean those materials partially containing amorphous components.

As the back electrode layer to be formed on the photoelectric conversion unit, for example, a metal layer, such as Al or Ag, may be formed by using a sputtering method or a vapor deposition method. In general, a conductive oxide layer, such as ITO (Indium Tin Oxide), SnO₂ or ZnO, is formed between the photoelectric conversion unit and the metal electrode layer.

Further, as a method for improving the conversion efficiency of the thin-film photoelectric conversion device, there has been known a method in which two or more photoelectric conversion units are stacked so as to form a stacked-type thin-film photoelectric conversion device. In this method, a front unit including a photoelectric conversion layer having a large energy-band gap is placed on a light incident side of a thin-film photoelectric conversion device, and behind this front unit, rear unit(s) having smaller band gaps are successively placed so that a photoelectric conversion process can be carried out over a wide wavelength range of incident light; thus, the conversion efficiency of the entire device can be improved. Among stacked-type thin-film photoelectric conversion devices, those in which an amorphous photoelectric conversion unit and a crystalline photoelectric conversion unit are stacked are referred to as hybrid-type thin-film photoelectric conversion devices.

In order to reduce the electric loss by resistance of the transparent electrode layer on the glass substrate, the patterning of the cells of the thin-film photoelectric conversion device is typically carried out by forming separation grooves that separate the transparent electrode into a plurality of short strip shapes having a specific width by laser scribing and connecting the cells in series in a direction orthogonal to the longitudinal direction of those short strip shapes.

Furthermore, the thin-film photoelectric conversion device may be washed after the stacking and the patterning process in order to remove residual materials. In general, the washing method is a high-pressure washing, ultrasonic washing or an alkali washing.

### PRIOR ART DOCUMENTS

### PATENT DOCUMENTS

Patent Document 1: International Publication Pamphlet No. WO/2003/021690
Patent Document 2: Japanese Patent Laid-Open Publication No. 2008-305945
Patent Document 3: International Publication Pamphlet No. WO/2008/149835

### SUMMARY OF THE INVENTION

### PROBLEMS TO BE SOLVED BY THE INVENTION

For example, Patent Document 1 and the like disclose forming a thin-film photoelectric conversion device by using a substrate in which a transparent electrode layer is deposited on a surface of a transparent base member. However, by this method, detachment between the layers of the transparent base member and the transparent electrode layer, for example, may occur in each of the steps of patterning by laser scribing at the time of forming the thin-film photoelectric conversion device, deposition of a photoelectric conversion unit, deposition of a back metal and washing the thin-film photoelectric conversion device. In particular, according to studies of the inventors, it has been found out that the detachment is liable to occur when a plurality of photoelectric conversion units are formed.

Also, Patent Documents 2 and 3 disclose introducing an underlying layer between the transparent base member and the transparent electrode layer in order to suppress the detachment between the layers of the transparent base member and the transparent electrode layer. Further, Patent Document 3 discloses that the energy density of a laser used for laser scribing is preferably lowered in order to avoid damages to the transparent electrode layer.

However, when the energy density of the laser at the time of laser scribing is lowered, defects such as short-circuits tends to occur due to residual stock removals in the separation grooves. For this reason, it has been difficult to simultaneously achieve all of the goals of suppressing the detachment; avoiding the damages to the transparent electrode layer; and eliminating the defect caused by the residual stock removals, only by adjusting a condition of laser irradiation.

### MEANS FOR SOLVING THE PROBLEMS

As a result of eager studies by the inventors, it has been unexpectedly found out that the goals can be achieved and a thin-film photoelectric conversion device with suppressed detachment or the like can be obtained by using a transparent base member having specific properties, thereby completing the invention.

The invention relates to a thin-film photoelectric conversion device having at least one photoelectric conversion and a back electrode layer formed on a substrate with transparent electrode layer. The substrate with transparent electrode layer comprises a transparent base member and a transparent underlying layer and a transparent electrode layer both stacked in this order on an underlying surface that is one main surface of the base member. The transparent electrode layer, the photoelectric conversion unit and the back electrode layer are separated from one another by a plurality of separation grooves so as to form a plurality of photoelectric conversion cells, and the plurality of photoelectric conversion cells are electrically connected to each other through a plurality of connection grooves.

A magnesium oxide content ratio in the transparent base member is from 0.2 to 2.0 wt%. The transparent underlying layer includes transparent insulating fine particles and transparent binder, and the transparent electrode layer includes zinc oxide deposited by a low-pressure CVD method.

In a preferable embodiment, said at least one photoelectric conversion unit includes an amorphous photoelectric conversion unit. In another preferable embodiment, said at least one photoelectric conversion unit includes a crystalline photoelectric conversion unit.

The invention also relates to a method for producing the thin-film photoelectric conversion device. The production method of the invention includes step of preparing the base member having a magnesium oxide content ratio in the transparent base member of from 0.2 to 2.0 wt%; step of forming the transparent underlying layer by using a coating solution including transparent insulating fine particles and transparent binder; step of depositing the transparent electrode layer including zinc oxide by low-pressure CVD method; step of depositing the photoelectric conversion unit, and step of depositing the back electrode layer. In an embodiment, the back electrode layer is depositing by sputtering method.

The transparent electrode layer, the photoelectric conversion unit and the back electrode layer are separated from one another by a plurality of separation grooves so as to form a plurality of photoelectric conversion cells; and the plurality of photoelectric conversion cells are electrically connected to each other through a plurality of connection grooves. At least a plurality of back electrode separation groove that penetrate through the photoelectric conversion unit and the back electrode layer are formed by laser scribing process

In a preferable embodiment, a laser energy density for forming a plurality of separation grooves on the back electrode layer is set to from 0.95 to 1.05 times larger than the energy that allow the separation grooves to be formed in the back electrode layer. In addition, a laser energy density for forming a plurality of separation grooves on the transparent electrode layer is set to from 0.95 to 1.05 times larger than the energy that allow the separation grooves to be formed in the transparent electrode layer. Further, a laser energy density for forming a plurality of separation grooves on the photoelectric conversion unit is set to from 0.95 to 1.05 times larger than the energy that allow the separation grooves to be formed in the photoelectric conversion unit.

Further, in a preferable embodiment, at least one kind of washing selected from the group consisting of an ultrasonic washing, a high-pressure washing, and an alkali washing is carried out after the formation of the back electrode separation grooves.

### EFFECTS OF THE INVENTION

According to the invention, a thin-film photoelectric conversion device having an improved adhesion between each layer may be obtained. In the thin-film photoelectric conversion device of the invention, detachment between layers can be suppressed even during a formation of separation grooves by laser scribing for integration or during a washing after the laser scribing. As a result, due to a suppression of the detachment and a reduction of residual stock removals in separation grooves, a thin-film photoelectric conversion device with improved properties can be obtained

### BRIEF DESCRIPTION OF THE DRAWINGS

FIG. 1 is a schematic sectional view showing a substrate with transparent electrode layer for a thin-film photoelectric conversion device and a thin-film photoelectric conversion device including thereof.
FIG. 2 is a schematic sectional view showing an integrated-type thin-film photoelectric conversion device.

### DESCRIPTION OF EMBODIMENTS

According to the studies of the inventors, it has been found out that, when a zinc oxide transparent electrode layer is formed on a transparent base member by a low-pressure CVD method (low-pressure chemical vapor deposition method), detachment of the transparent electrode layer may occur in forming the separation grooves by laser scribing that is a step of integrating the thin-film photoelectric conversion device, in depositing one or more photoelectric conversion units, in depositing a back electrode, or in washing after each step. Here, such detachment of the transparent electrode is a phenomenon that is not seen when a zinc oxide transparent electrode layer is formed on the transparent base member by a sputtering method.

In addition, the detachment of the transparent electrode layer is suppressed when a transparent underlying layer is formed on the transparent base member and the zinc oxide transparent electrode layer is formed thereon by a low-pressure CVD method. However, it has been found out that, when only the transparent underlying layer is simply formed, adhesion force between the transparent base member and the transparent underlying layer is not sufficient. In contrast, it has been found out that, by increasing the adhesion force between the transparent base member and the transparent underlying layer, the fill factor (FF) and the open-circuit voltage (Voc) of the thin-film photoelectric conversion device after the integration are lowered, whereby the conversion efficiency (Eff) is improved.

The reason therefor is not necessarily clear; however, it seems to be related to the adhesion force of the transparent underlying layer or the transparent electrode layer to the transparent base member and the condition for production in each step of forming the thin-film photoelectric conversion device. That is, it seems that, when the adhesion force between the transparent base member and the layer stacked thereon is small, the energy at the time of laser scribing in forming the separation grooves for integration in each layer will be larger as compared with the adhesion force, so that the detachment occurs starting from the site at which the separation grooves are formed.

Further, it seems that, in depositing a photoelectric conversion unit on the transparent electrode layer, stress is imparted also to the upper surface of the transparent electrode layer in a state in which the stress has already been imparted to the lower surface of the transparent electrode layer, so that the detachment is promoted. Furthermore, it seems that, when the back electrode layer is formed on the photoelectric conversion unit, the stress is also imparted to the upper surface of the photoelectric conversion unit, so that the detachment can occur. Also, it seems that, when the number of stacked layer is increased, for example, when a plurality of photoelectric conversion units are stacked, such detachment is more liable to occur. In addition, it seem that the washing after forming each of the layers and/or the washing after forming the separation grooves imposes a physical load or a chemical load upon each layer, thereby giving a cause of the above detachment.

According to the invention, the above detachment is suppressed by increasing the adhesion force between the layers, particularly the adhesion force between the transparent base member and the transparent underlying layer in a substrate with the transparent electrode layer and the adhesion force between the transparent underlying layer and the transparent electrode layer, whereby a thin-film photoelectric conversion device having high photoelectric conversion properties even after the integration is obtained. In the present invention, the detachment is effectively suppressed and high photoelectric conversion properties can be achieved particularly in a thin-film photoelectric conversion device in which a plurality of photoelectric conversion units are stacked, for example, a so-called hybrid solar cell.

Based upon the above studies, preferred embodiments of the present invention will be described with reference to the drawings. In the drawings of the present application, dimensions such as thickness and width are changed on demand for clarifying and simplifying the drawings, so that the actual dimensional relationships are not shown. Moreover, in the drawings of the present application, the same reference numerals represent the same portions or the corresponding portions.

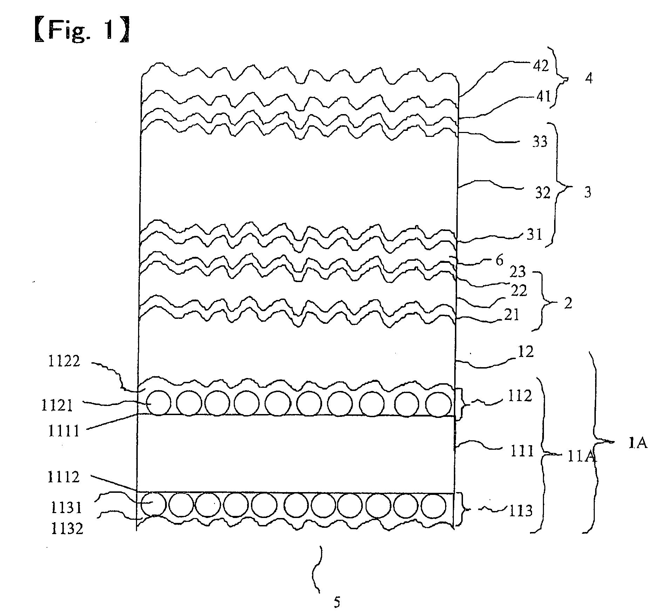

Fig. 1 is a cross-sectional view schematically showing one embodiment of a substrate with transparent electrode layer 1A for thin-film photoelectric conversion device, and a photoelectric conversion device 5 having photoelectric conversion units, and a back electrode layer formed on the substrate. In the substrate with transparent electrode layer 1A for thin-film photoelectric conversion device, a transparent underlying layer 112 and a transparent electrode layer 12 are formed on one main surface 1111 of a transparent base member 111. It is preferable that a transparent antireflection layer 113 is formed on the other main surface 1112 of the transparent base member 111. Photoelectric conversion unit(s) is formed on a transparent electrode layer 12 side surface of the substrate 1A with transparent electrode layer. In Fig. 1, a two-junction-type photoelectric conversion unit including a front photoelectric conversion unit 2, an intermediate transmissive-reflective layer 6 and a rear photoelectric conversion unit 3 is illustrated

Since the transparent base member 111, the transparent underlying layer 112 and the transparent antireflection layer 113 are arranged in a light-incident-side of the thin-film photoelectric conversion device 5, it is preferable that these layers are as transparent as practical so that more sunlight is pass through to be absorbed in the photoelectric conversion units 2, 3.

As the transparent base member 111, a glass plate, a plate-like member or a sheet-like member made of a transparent resin, or the like, is mainly used. In particular, the use of a glass plate as the transparent base member 111 is preferable because it has high transmittance and is inexpensive.

As mentioned earlier, the invention seeks to increase adhesion force between the stacked layers to suppress an occurrence of detachment during stacking and integrating, and thereby improve photoelectric conversion properties. It is known, in general, that controlling a surface shape is important for improving adhesion of a thin-film.

In contrast, the present invention has been made based on new knowledge that, when the magnesium oxide content in the transparent base member 111 such as represented by glass is within a specific range, the adhesion force between the transparent base member and the transparent underlying layer is outstandingly improved. That is, according to the studies of the present inventors, it has been found out that the adhesion force between the transparent base member and the transparent underlying layer is outstandingly improved when the content ratio of magnesium oxide in the transparent base member is set to from 0.2 to 2.0 wt%.

In the production of glass, MgO is blended for the purpose of improving the durability of glass as well as alleviating the temperature gradient of viscosity and decreasing the loss of transparency. From the above viewpoint, a more preferable range of the content ratio (in the total composition) of magnesium oxide (MgO) in the transparent base member 111 is from 0.2 to 0.5 wt%. The reason why the adhesion between the transparent base member 111 and the transparent underlying layer 112 is improved depending on the content of magnesium oxide is not necessarily clear. However, it is inferred that, at the time of anchoring the transparent underlying layer to the transparent base member, magnesium oxide or a substance derived from magnesium oxide within the transparent base member will be impurity to decrease the bonding area. The composition ratio (wt%) of an arbitrary component in the transparent base member can be measured, for example, by a known method such as fluorescence X-ray analysis or chemical analysis.

In addition, in the same manner as in the relationship between the content ratio of magnesium oxide and the adhesion force, when the transparent base member 111 is a transparent glass base member, the content ratios of other subcomponents are preferably as follows.

Besides SiO₂ which is a principal component, Fe₂O₃ may be contained as a subcomponent. This is an impurity contained in silicic acid which is a main source material of glass. Fe₂O₃ is removed by purification at a stage of the source material; however, excessive purification has poor efficiency, leading to an increase in the production costs of the glass base member. Also, when the purification is not carried out, the transmittance in a long wavelength range of the glass base member tends to be aggravated. In consideration of a balance among these, the Fe₂O₃ composition ratio is set to preferably from 0.005 to 0.015 wt%, and more preferably to from 0.010 to 0.015 wt%.

K₂O is used for the purpose of alleviating the temperature gradient of viscosity in the production of glass; however, K₂O tends to form carbonate by reacting with CO₂ in air to cause surface degradation. By suppressing this surface degradation, the baking temperature at the time of forming a functional layer on the transparent glass base member can be lowered. From above-mentioned viewpoint, K₂O composition ratio in the transparent glass base member is set to preferably 0.5 wt% or less, more preferably to 0.2 wt% or less, and especially preferably to 0.1 wt% or less.

The transparent grass base member may properly include other accessory component such as Al₂O₃, CaO, Na₂O, SO₃, and the like. For example, Al₂O₃ composition ratio is set to preferably from 0 to 5 wt%, more preferably to from 0.2 to 1.5 wt%. CaO composition ratio is set to preferably from 5 to 15 wt%, more preferably to from 8 to 12 wt%. Na₂O composition ratio is set to preferably from 10 to 20 wt%, more preferably to from 12 to 18 wt%. SO₃ c composition ratio is set to preferably from 0 to 3 wt%, more preferably to from 0 to 1 wt%.

The transparent underlying layer 112 and the transparent antireflection layer 113 may be formed by applying transparent fine particles 1121 and 1131 onto the transparent base member 111 together with, for example, a binder forming ingredients containing a solvent.

Specifically, as the transparent binders 1122 and 1132, metal oxides, such as a silicon oxide, an aluminum oxide, a titanium oxide, a zirconium oxide and a tantalum oxide, may be utilized. More specific, metal alkoxide, utilizing a metal such as a silicon, an aluminum, a titanium, a zirconium and a tantalum may be exemplified. Among then, silicon alkoxide has low refraction index and thus is preferably utilized for antireflection layer and transparent underlying layer. Monomer or oligomer (partially hydrolyzed condensate having condensation degree of from 2 to 10) of one kind or two or more kind of tetramethoxysilane, tetraethoxysilane, tetrapropoxysilane, tetrabuthoxysilane and the like are preferably utilized as the silicon alkoxide.

Further, as the transparent fine particles 1121 and 1131, materials, such as silica (SiO₂), titanium oxide (TiO₂), aluminum oxide (Al₂O₃), zirconium oxide (ZrO₂), indium tin oxide (ITO), or magnesium fluoride (MgF2), may be used.

As the method for applying a coating solution to the transparent base member 111, methods, such as a dipping method, a spin coating method, a bar-coating method, a spraying method, a die coating method, a roll coating method (printing method) and a flow coating method, may be used. In order to uniformly and densely form transparent fine particles, the dipping method or the roll coating method is preferably used. Upon completion of the application of the coating solution, the coating solution may be heated and dried immediately. In order to uniformly form fine surface irregularities on the transparent underlying layer 112 as well as on the transparent antireflection layer 113, the shapes of the transparent fine particles 1121 and 1131 are preferably set to spherical shapes.

In the dipping method, it is preferable to wash a transparent base member before the underlying layer and/or the antireflection layer are formed thereon. In the case where a glass substrate is used as the transparent base member, it is preferable to wash the glass base member prior to the formation of the underlying layer and/or the antireflection layer so that an adhesive carbon component and burned spot on the glass base member surface are removed. The washing methods for the glass base member include an ultrasonic washing process, a plasma washing process, an alkali washing process, a Cerico washing process and the like. In order to remove the burned spot that corresponds to a denatured component on the glass surface that has been chemically changed, a chemical removing process or a physical removing process, such as polishing, is preferably carried out. Therefore, among the above-mentioned washing methods, the plasma washing method, the alkali washing method and the Cerico washing process are preferably selected. In the case of the plasma washing process, although the carbon component and the burned spot on the glass surface can be removed by using carbon tetrafluoride plasma, glass components, such as Mg, Na, Ca and Al, are left on the glass surface. In the case of the alkali washing process, a film (barrier) of sodium silicate is formed on the glass surface, and since alkali reacts through the barrier, the surface is formed into a porous state. In the case of the Cerico washing method, there are caused no problems such as residual foreign matters on the glass surface and changes in the surface shape, and the controlling process of the washing is easily carried out. Therefore, among the washing methods, the Cerico washing method is preferably selected.

Here, the Cerico washing will be described. The Cerico washing is a general method for polishing and washing the glass. The "Cerico washing" refers to a method for carrying out polishing and washing processes by using a polishing slurry mainly composed of water and cerium oxide, and in its mechanism, cerium oxide and water are allowed to approach silicon oxide on a glass surface by the function of compressive stress to form Si(OH)₄ through a chemical reaction so as to be eluted into the solution. In the washing method, the polishing slurry composed of water and cerium oxide is put on a cloth or sponge, and the glass is rubbed with this so that the Cerico washing is preferably carried out. More preferably, a polishing buff secured onto a sponge made of, for example, polyvinyl alcohol is allowed to absorb water, and the washing process is carried out, with cerium oxide particles being pressed onto the glass surface by the polishing buff. After the Cerico washing, the resulting glass is preferably rinsed with pure water and washed.

By washing the glass surface using the Cerico washing as described above, the impurities such as MgO on the glass surface is effectively washed away, whereby silicon oxide contained in the glass is more likely to be exposed to the surface. For this reason, the composition ratio of silicon oxide can be relatively raised and the composition ratio of the impurities such as MgO can be relatively lowered on the glass surface. Therefore, by performing the Cerico washing on the glass surface, the bonding area is increased by removal of the impurities, and the bonding force of the transparent fine particles and the transparent binder to the glass surface tends to increase. In particular, when a silicon-based material such as silicon alkoxide is used as the binder, the bonding force tends to increase, also due to the increase in the composition ratio of silicon oxide on the glass surface, so that it is preferable to adopt the Cerico washing as a method for washing the glass.

As the material for the transparent electrode layer 12 on the transparent underlying layer 112, zinc oxide (ZnO) is preferably utilized. As its doping impurities, at least one kind selected from the group consisting of B, Al and Ga is preferably contained therein, and in particular, it is preferable to contain B atoms at a concentration of 2 x 10¹⁹ atoms/cm³ or more. Moreover, in addition to the doping impurities, it is also preferable to contain H atoms at a concentration of 2 x 10²⁰ atoms/cm³ or more. In the ZnO layer containing H, since surface irregularities capable of generating a light confinement effect is easily formed, it is desirably used as a transparent electrode layer for the thin-film photoelectric conversion device.

In the present invention, the ZnO transparent electrode layer 12 of a substrate 1 for a thin-film photoelectric conversion device is formed by a low-pressure thermal CVD method. The ZnO transparent electrode layer is preferably formed at a deposition temperature of 200°C or less. The deposition temperature of the transparent electrode layer 12 refers to a temperature of the surface of the base member 11 that is in contact with the heating unit of the CVD device.

In the deposition of the ZnO transparent electrode layer 12, diethyl zinc (also referred to as DEZ) or dimethyl zinc, serving as organic metal vapor, water serving as oxidant vapor, and B₂H₅ serving as a doping gas, are preferably used. As a diluting gas, at least one kind selected from the group consisting of H₂, He and Ar are used. A mixed gas thus prepared is preferably directed to a reduced-pressure vessel under a pressure of 5 to 200 Pa. The deposition temperature is preferably set to 200°C or less, more preferably, in a range from 140°C to 170°C. The flow rate of DEZ may be set to 10 to 1000 sccm, the flow rate of water may be set to 10 to 1000 sccm, the flow rate of H₂ may be set to 100 to 10000 sccm, and the flow rate ofAr may be set to 100 to 10000 sccm, respectively. The concentration of B₂H₆ is preferably set to 0.1 to 10 volume % relative to DEZ.

As the transparent electrode layer (ZnO layer) 12 to be deposited, a thin-film having a crystalline grain size in a range of substantially from 50 to 500 nm, with surface irregularities having a highest-to-lowest height difference in a range of substantially from 20 to 200 nm, is preferably used from the viewpoint of obtaining an appropriate light confinement effect of the thin-film photoelectric conversion device. Moreover, the haze ratio of the substrate 1 with transparent electrode including the ZnO layer 12 is preferably set to 15% or more, and more preferably, to 20% or more from the viewpoint of obtaining the light confinement effect of the thin-film photoelectric conversion device.

The sheet resistance of the ZnO layer 12 is preferably set to 15 Ω/square or less, more preferably, to 10 Ω/square or less, from the view point of suppressing the resistance loss.

The average thickness of the ZnO layer 12 may be set adequately for any purpose, and is preferably set to 0.7 to 5 µm, more preferably to 1 to 3 µm. The reason for this is because, when the ZnO film is too thin, it becomes difficult to produce sufficient surface irregularities required for efficiently exerting the light confinement effect and to obtain conductivity required for the transparent electrode layer. On the other hand, in the case where the ZnO layer is too thick, the quantity of light to reach the photoelectric conversion unit is reduced due to light absorption of the film itself, causing degradation of the photoelectric conversion efficiency. Moreover, in the case where the ZnO film is too thick, the cost for deposition tends to increase due to an increase in deposition time.

In the case where an amorphous silicon-based material is selected for the front photoelectric conversion unit 2, it shows a sensitivity to light rays having wavelengths of about 360 to 800 nm. While, in the case where a crystalline silicon-based material is selected for the rear photoelectric conversion unit 3, it shows a sensitivity to light rays having up to about 1200 nm, which is longer than that of the front photoelectric conversion unit.. Therefore, in the case of the hybrid-type thin-film photoelectric conversion device 5 in which the front photoelectric conversion unit 2 made of the amorphous silicon-based material and the rear photoelectric conversion unit 3 made of the crystalline silicon-based material are stacked in this order from the light incident side, it becomes possible to effectively utilize incident light rays within a wider wavelength range. In this case, the "silicon-based materials" include not only silicon but also silicon alloy semiconductor materials such as silicon carbide and silicon germanium.

In order to improve the conversion efficiency of the stacked-type thin-film photoelectric conversion device, there is proposed a method in which an intermediate transmissive-reflective layer 6, made of a material having a conductive property and a refractive index lower than that of the material forming the photoelectric conversion units 2 and 3, is formed between the thin-film photoelectric conversion units 2 and 3. Such an intermediate transmissive -reflective layer 6 can be designed so as to reflect light rays with shorter-wavelength, while allowing light rays with longer-wavelength side to transmit therethrough, so that the respective thin-film photoelectric conversion units 2 and 3 can more effectively carry out the photoelectric conversion process.

In the case where the intermediate transmissive-reflective layer 6 is inserted between the front amorphous silicon photoelectric conversion unit 2 and the rear crystalline silicon photoelectric conversion unit 3, it is possible to increase a current generated by the front unit 2, without the necessity of increasing a film thickness of an amorphous silicon photoelectric conversion layer 22. Moreover, in the case where the intermediate transmissive-reflective layer 6 is included, since the thickness of the amorphous silicon photoelectric conversion layer 22 required for obtaining the same current value can be made smaller in comparison with the structure without the intermediate transmissive-reflective layer 6, it is possible to suppress a reduction in the characteristic of the amorphous silicon photoelectric conversion unit 2 due to photodegradation (Staebler-Wronsky effect) that becomes conspicuous in response to an increase in thickness of the amorphous silicon layer.

Although the intermediate transmissive-reflective layer may be inserted between the front photoelectric conversion unit and the rear photoelectric conversion unit, it may also be formed as one portion of the rear conductive layer in the front photoelectric conversion unit, or may also be formed as one portion of the front conductive layer in the rear photoelectric conversion unit.

The front photoelectric conversion unit 2 is formed by depositing, for example, a p-layer, an i-layer and an n-layer in this order by a plasma enhanced CVD method. More specifically, a p-type amorphous silicon carbide layer 21 doped with 0.01 atomic % or more of boron, a photoelectric conversion layer 22 made of substantially i-type amorphous silicon, and an n-type microcrystalline silicon layer 23 doped with 0.01 atomic % or more of phosphorous are deposited in this order.

As the material for the intermediate transmissive-reflective layer 6, a conductive metal oxide such as zinc oxide or ITO may be used, and a silicon-based composite material containing microcrystalline silicon and silicon oxide that can be formed by a plasma enhanced CVD method in the same manner as in the amorphous silicon layer and the crystalline silicon layer may be used. In the case of the integrated-type device, the use of the conductive oxide as the intermediate transmissive-reflective layer 6 may cause a problem of a short-circuit in the rear photoelectric conversion unit; however, the use of the silicon-based composite material having a comparatively high resistance makes it possible to avoid this problem, and is preferably employed. The silicon-based composite layer is preferably formed by using a plasma enhanced CVD method in which, for example, SiH₄, CO₂ H₂ and PH₃ are used as reaction gases, with a large H₂/SiH₄ ratio of from 10 to 1000, preferably 50 to 500, that is a so-called microcrystalline silicon forming condition being set, and a CO₂/SiH₄ ratio relating to silicon oxide is set to 2 or more. In this plasma enhanced CVD method, for example, by using capacity-coupled-type parallel flat electrodes, the processes are preferably carried out under conditions of a power-supply frequency in a range from 10 to 100 MHz, a high-frequency power density of 0.01 to 0.5 W/cm², a pressure in a range from 50 to 1500 Pa and a deposition temperature in a range from 150 to 250°C. When the CO₂/SiH₄ ratio is increased, the oxygen concentration in the film monotonically increases, thereby making it possible to lower the refractive index of the intermediate transmissive-reflective layer 6.

The rear photoelectric conversion unit 3 is also formed by depositing, for example, a p-layer, an i-layer and an n-layer in this order by the plasma enhanced CVD method. More specifically, a p-type microcrystalline silicon layer 31 doped with 0.01 atomic % or more of boron, a photoelectric conversion layer 32 made of substantially i-type crystalline silicon, and an n-type microcrystalline silicon layer doped with 0.01 atomic % or more of phosphorous are deposited in this order.

As the back electrode layer 4, at least one kind of material, selected from the group consisting of Al, Ag, Au, Cu, Pt and Cr, is preferably deposited as at least one metal layer 42 by using a sputtering method or a vapor deposition method. Moreover, a conductive oxide layer 41 such as ITO, SnO₂ or ZnO is preferably formed as one portion of the back electrode layer 4, between the metal layer 42 and the photoelectric conversion unit 3. The conductive oxide layer 41 enhances the adhesion between the back electrode layer 4 and the photoelectric conversion unit 3 adjacent thereto, while increasing the light reflectance of the back electrode layer 4, and further has a function for preventing chemical changes of the photoelectric conversion units 3 and 2.

As shown in Fig. 1, the thin-film photoelectric conversion device may include a stack of two photoelectric conversion units; however, needless to say, it may have a single cell structure including only one photoelectric conversion unit, or a so-called triple cell structure including a stack of three photoelectric conversion units, or a multiple cell structure including four or more photoelectric conversion units. For example, the thin-film photoelectric conversion device may have an amorphous single cell structure in which only the amorphous silicon photoelectric conversion unit corresponding to the front photoelectric conversion unit 2 of Fig. 1 is formed, with the intermediate transmissive-reflective layer 6 and the rear photoelectric conversion unit 3 being omitted. Moreover, ZnO is used in the transparent electrode layer 12 of the Examples of the invention, and since ZnO has a higher plasma resistant characteristic in comparison with SnO₂, a crystalline silicon photoelectric conversion unit can be directly formed on the transparent electrode layer 12. That is, in the present invention, a crystalline single cell, which includes only the crystalline silicon photoelectric conversion unit 3 in Fig. 1, with the front photoelectric conversion unit 2 and the intermediate transmissive-reflective layer 6 being omitted, may also be used. Moreover, as one example of the triple cell structure, three photoelectric conversion units such as an amorphous silicon photoelectric conversion unit/an amorphous silicon germanium photoelectric conversion unit including substantially an i-type amorphous silicon germanium layer/a crystalline silicon photoelectric conversion unit may be stacked in this order. Furthermore, three photoelectric conversion units such as an amorphous silicon photoelectric conversion unit/a crystalline silicon photoelectric conversion unit/a crystalline silicon photoelectric conversion unit may be stacked in this order.

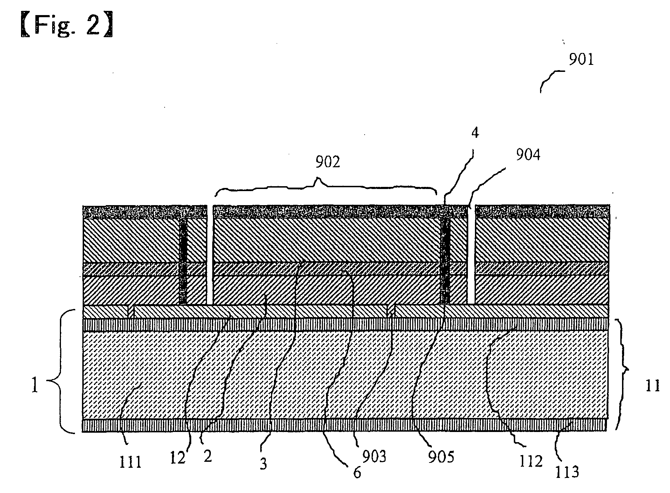

Fig. 2 is a cross-sectional view schematically showing an integrated-type thin-film photoelectric conversion device of the present invention. In the integrated-type thin-film photoelectric conversion device 901, on a transparent insulating base member 11 including a transparent base member (glass plate) 111 and a transparent underlying layer 112, a transparent electrode layer 12, a front photoelectric conversion unit 2 serving as an amorphous silicon photoelectric conversion unit, an intermediate transmissive-reflective layer 6, a rear photoelectric conversion unit 3 serving as a crystalline silicon photoelectric conversion unit, and a back electrode layer 4 are successively stacked in this order.

Moreover, in the integrated-type thin-film photoelectric conversion device 901 of Fig. 2, first and second separation grooves 903, 904, and a connection groove 905 are formed. The first and second separation grooves 903, 904 and the connection groove 905 are in parallel with each other, and extended in a direction perpendicular to the drawing surface of Fig. 2. Note that the boundary area between adjacent photoelectric conversion cells 902 is defined by the first and second separation grooves 903, 904 that are closely located thereto.

The first separation groove 903 divides the transparent electrode layer 12 in association with the respective photoelectric conversion cells 902. The second separation groove 904 divides the front photoelectric conversion unit 2, the intermediate transmissive-reflective layer 6, the rear photoelectric conversion unit 3 and the back electrode layer 4 in association with the respective photoelectric conversion cells 902. The connection groove 905 penetrates the front photoelectric conversion unit 2, the intermediate transmissive-reflective layer 6 and the rear photoelectric conversion unit 3, and is embedded with a metal material forming the back electrode layer 4 so that the back electrode layer 4 on one side and the transparent electrode layer 12 on the other side of the adjacent photoelectric conversion cells 902 are electrically connected with each other. That is, the connection groove 905 is formed so as to make the photoelectric conversion cells 902, placed side by side on the transparent insulating base member 11, serially-connected to one another.

A laser scribing method is suitably used for forming the first separation groove 903. In forming the separation groove 903, the transparent underlying layer 112 remains on the transparent base member 111 without being removed, and only the transparent electrode layer is separated. When residual stock removals are locally generated in the separation groove, the insulation between adjacent cells is lowered. Therefore, the energy density of laser scribing for forming the separation groove 903 needs to be increased so that no residual stock removals may be generated. On the other hand, when the energy density increases, heat is conducted to the surroundings of the separation groove, so that the film quality of the transparent electrode layer 12 may be lowered, or a local detachment may occur from the marginal portions of the separation groove 903. Therefore, the laser energy density in forming the first separation groove 903 that divides the transparent electrode layer 12 is preferably set to from 0.95 to 1.05 times larger than the energy density that can form a separation groove in the transparent electrode layer 12. In the present invention, because a specific base member is used as described above, the adhesion force between the transparent base member and the transparent underlying layer is improved. Therefore, when the energy density for forming the separation groove in the transparent electrode layer is within the above range, occurrence of short-circuit by residual stock removals is suppressed while the local detachment is suppressed from the separation groove marginal portions, so that an integrated-type thin-film photoelectric conversion device having high photoelectric conversion properties can be obtained. In forming the separation groove, the laser energy density can be set within a specific range by adjusting the output, focal depth, dot diameter and the like of the laser.

The laser scribing method is suitably used also for forming the connection groove 905. In forming the connection groove 905, the transparent underlying layer 112 and the transparent electrode layer 12 are not removed, and the front photoelectric conversion unit 2, the intermediate transmissive-reflective layer 6, and the rear photoelectric conversion unit 3 are removed. Because the back electrode layer is formed after the connection groove 905 is formed, the connection groove is filled with a metal material constituting the back electrode layer 4. When the energy density of the laser for forming the connection groove 905 increases, heat is conducted to the surroundings of the connection groove, whereby the film quality of the photoelectric conversion units 2, 3 may be lowered. Also, when the energy density of the laser is increased in the case of irradiating the laser from the transparent insulating base member 11 side, detachment of the transparent electrode layer 12 or the photoelectric conversion units may occur in the peripheries of the connection groove 905 in addition to the fact that the film quality of the transparent electrode layer 12 may be lowered. Therefore, the laser energy density for forming the connection groove 905 is preferably set to from 0.95 to 1.05 times larger than the energy density that can remove the photoelectric conversion units.

The laser scribing method is suitably used also for forming the second separation groove 904. In forming the second separation groove 904, the transparent underlying layer 112 and the transparent electrode layer 12 are not removed, while all of the layers formed thereon, namely the front photoelectric conversion unit 2, the intermediate transmissive-reflective layer 6, the rear photoelectric conversion unit 3 and the back electrode layer 4, are removed. When residual stock removals are locally generated in the second separation groove, the insulation between adjacent cells is lowered. Therefore, the energy density of laser scribing for forming the separation groove 904 needs to be increased so that no residual stock removals may be generated. On the other hand, when the energy density increases, heat is conducted to the surroundings of the separation groove, so that the film quality of the photoelectric conversion units 2, 3 may be lowered. Also, when the energy density of the laser is increased in the case of irradiating the laser from the transparent insulating base member 11 side, detachment of the transparent electrode layer 12 or the photoelectric conversion units may occur in the peripheries of the separation groove 904 in addition to the fact that the film quality of the transparent electrode layer 12 may be lowered. Therefore, the laser energy density for forming the separation groove 904 separating the back electrode layer is preferably set to from 0.95 to 1.05 times larger than the energy density that can form a separation groove in the back electrode layer 4.

In the present invention, because a specific transparent base member is used as described above, the adhesion force between the transparent base member and the transparent underlying layer is improved. For this reason, when the energy density for forming the separation groove in the transparent electrode layer is set to within the above range, an occurrence of local detachment from the separation groove marginal portions, as well as an occurrence of short-circuit due to residual stock removals, are suppressed even when the back electrode separation groove 903 is formed by irradiating the laser from the transparent insulating base member 11 side. For this reason, an integrated-type thin-film photoelectric conversion device having high photoelectric conversion properties can be obtained.

In Fig. 2, an example is illustrated in which a plurality of photoelectric conversion cells are connected in series by the separation grooves 903, 904 and the connection groove 905; however, the present invention is not limited to such an embodiment. A method of integration is not particularly limited as long as at least a plurality of separation grooves that separate the transparent electrode layer 12 and at least a plurality of separation grooves that separate the back electrode layer 4 are formed so as to form a plurality of photoelectric conversion cells, and the photoelectric conversion cells are connected in series or in parallel.

After forming the separation groove 904, it is preferable that various washings such as an ultrasonic washing, a high-pressure washing and an alkali washing are carried out in order to remove the impurities and the residual stock removals (residues) in the separation groove. By the ultrasonic washing, a physical load by vibration can occur; by the high-pressure washing, a physical load by pressure can occur; and by the alkali washing, a chemical load such as elution can occur, thereby causing occurrence of detachment. For this reason, generally the washing is preferably carried out under a moderate condition. In contrast, in the present invention, since a specific transparent base member is used, the adhesion force between the transparent base member and the transparent underlying layer is improved, so that detachment at the time of the washing hardly occurs. For this reason, even when the laser density for forming the separation groove or the connection groove is suppressed as described above, residual stock removals can be removed by adopting washing under a relatively severe condition, while the detachment is suppressed. Therefore, an integrated-type thin-film photoelectric conversion device having high photoelectric conversion properties is obtained.

### EXAMPLES

Hereinafter, various examples of the present invention will be described in more detail, together with various comparative examples and reference examples. It is needless to say that the present invention is not limited to the following examples, and various changes may be made within the scope not departing from the gist of the invention.

Process conditions (magnesium oxide content in grass substrate, with or without underlying layer, energy density for forming back electrode separation grooves and number of washing) and photoelectric conversion properties (open-circuit voltage (Voc), short-circuit current density (Jsc), fill factor (FF) and conversion efficiency (Eff)) of the integrated-type thin-film photoelectric conversion devices of each Examples, Comparative Examples and Reference Example are summarized in Table 1

**[Table 1]**

| | Process conditions | | | | Photoelectric conversion properties | | | |
|---|---|---|---|---|---|---|---|---|
| | MgO Content (wt%) | With or without underlying-layer | Energy density (J/cm²) | Number of washing | Voc (V) | Jsc (mA/cm²) | FF (%) | Eff (%) |
| Example 1 | 0.3 | with | 0.6 | 1 | 1.323 | 12.63 | 0.712 | 11.90 |
| Preference Example 1 | 0.3 | with | 0.7 | 1 | 1.311 | 12.58 | 0.704 | 11.61 |
| Example 2 | 0.3 | with | 0.6 | 3 | 1.335 | 12.71 | 0.721 | 12.23 |
| Comparative Example 2 | 4.2 | with | 0.6 | 1 | 1.305 | 12.61 | 0.698 | 11.49 |
| Comparative Example 3 | 4.2 | with | 0.7 | 1 | 1.289 | 12.55 | 0.651 | 10.53 |
| Comparative Example 4 | 4.2 | with | 0.6 | 3 | 1.315 | 12.58 | 0.701 | 11.60 |
| Comparative Example 1 | 0.3 | without | 0.6 | 1 | 1.220 | 12.37 | 0.656 | 9.90 |

(Example 1)

A thin-film photoelectric conversion device was produced as Example 1 of the present invention. First, a transparent underlying layer 112 and transparent antireflection layer 113 each including SiO₂ fine particles 1121, 1131 and binder 1122, 1132 were formed on an underlying surface 1111 of a glass plate 111 and on an antireflection layer opposite to the underlying surface 1111 of the glass plate, respectively so as to obtain a transparent insulating base member 11A.. The glass plate 111 had a thickness of 4 mm, an area of 360 mm x 465 mm and weight % content ratio shown in Table 1. Herein, the component shown in Table 2 was analyzed by X-ray photoelectron spectroscopy (XPS) method.

**[Table 2]**

| SiO₂ | Fe₂O₃ | Al₂O₃ | CaO | MgO | K₂O | Na₂O | SO₃ |
|---|---|---|---|---|---|---|---|
| 73 | 0.013 | 1 | 10 | 0.3 | 0.04 | 14 | - |

Upon forming the transparent underlying layer 112 and the transparent antireflection layer 113, first, the glass substrate was subjected to a Cerico washing process. Specifically, water was absorbed in a polishing buff in which cerium oxide was fixed onto a sponge made of polyvinyl alcohol, and by pressing this onto the transparent base member, the Cerico washing process was carried out at a revolution of 2000 rpm and a moving rate of 30 mm/sec. At this time, the washing process was carried out with a pressing pressure onto the underlying surface being set to 4 kgf, and the substrate was then rinsed with pure water and washed. Thereafter, the substrate was dried at 80°C for 30 minutes.

A coating solution to be used upon forming the transparent antireflection layer 113 and the transparent underlying layer 112 was prepared by stirring and mixing water, isopropyl alcohol, hydrochloric acid, oligomer (n = 4 to 6) of tetraethoxy silane, and a dispersion solution of silica fine particles (water solvent, solid component: 40%) having an average particle size of 90 nm. By using a dip coating method in which the glass substrate was immersed in this coating solution and pulled out at a rate of 0.115 m/sec, coating processes of the transparent underlying layer 112 and the transparent antireflection layer 113 were simultaneously carried out. Thereafter, the substrate was subjected to a baking process at 200°C for 5 minutes so that a transparent insulating base member 11A having fine irregularities formed on its surface was obtained.

The adhesion strength of the transparent insulating base member 11A obtained in the present example was evaluated in accordance with an abrasion testing method by an abrasion wheel described in JIS K7204. Specifically, the rotation wheel of the abrasion wheel CS10F was pressed onto an antireflection layer by a pressure of 9.8 N, and the antireflection layer was rotated by 72 rpm (60 Hz), and the number of revolutions until the layer was completely detached was measured. As a result, the adhesion strength of the transparent insulating base member 11A obtained in the present example was 5000 revolutions. Also, a similar test was carried out on the transparent underlying layer. The adhesion strength of the transparent insulating base member 11A was 5000 revolutions.

On the transparent underlying layer 112 of the insulating base member 11A thus obtained, a transparent electrode layer 12 made of ZnO was formed by using a low-pressure CVD method so that a substrate 1A with transparent electrode for thin-film photoelectric conversion device was obtained. This transparent electrode layer 12 was formed under conditions of a substrate temperature of 150°C, a pressure of 30 Pa, a flow-rate of vaporized diethyl zinc (DEZ) of 200 sccm, a flow-rate of vaporized water of 700 sccm, a flow-rate of vaporized diborane (B₂H₆) of 2 sccm and a flow-rate of hydrogen of 1000 sccm.

In the resulting transparent electrode layer 12 made of a ZnO, the thickness, obtained from interference of reflection spectra, was 1.8 µm, the sheet resistance was 11.9 Ω/square, and the haze ratio, measured by using an illuminant C, was 30.3%.

On the substrate 1A with transparent electrode layer thus obtained, an amorphous silicon photoelectric conversion unit 2, an intermediate transmissive-reflective layer 6, a crystalline silicon photoelectric conversion unit 3 and a back electrode layer 4 were successively formed to obtain a hybrid-type thin-film photoelectric conversion device. In this case, the thin-film photoelectric conversion device of Example 1 was manufactured as an integrated-type thin-film photoelectric conversion device 901 as shown in Fig. 2, by utilizing a laser scribing process.

Upon forming the integrated-type thin-film photoelectric conversion device 901, a YAG (yttrium-aluminum-garnet) laser having a wavelength of 1064 nm and an energy density of 13 J/cm² was used so that separation grooves 903 were formed in a transparent electrode layer 12. Thereafter, the resulting substrate 1 with transparent electrode layer was washed and dried.

On the transparent electrode layer 12 that had been laser-processed, a p-type layer 21 made of stacked layers of a p-type microcrystalline silicon layer having a thickness of 10 nm and a p-type amorphous silicon carbide layer having a thickness of 15 nm, an i-type amorphous silicon photoelectric conversion layer 22 having a thickness of 350 nm and an n-type microcrystalline silicon layer 23 having a thickness of 15 nm were successively stacked by using a plasma enhanced CVD method so that a front photoelectric conversion unit 2 was formed. Successively, an intermediate transmissive-reflective layer 6 made of a silicon-based composite layer having a thickness of 50 nm was formed by the plasma enhanced CVD method. Further, a p-type microcrystalline silicon layer 31 having a thickness of 15 nm, an i-type crystalline silicon photoelectric conversion layer 32 having a thickness of 2.5 µm and an n-type microcrystalline silicon layer 33 having a thickness of 15 nm were successively deposited by the plasma enhanced CVD method so that a rear photoelectric conversion unit 3 was formed.

Thereafter, by using the second harmonic (wavelength: 532 nm) of the YAG laser, connection grooves 905 penetrating the front photoelectric conversion unit 2, the intermediate transmissive-reflective layer 6 and the rear photoelectric conversion unit 3 were formed.

After the formation of the connection grooves 905, as a back electrode layer 4 on the rear photoelectric conversion unit 3, a ZnO layer 41 doped with Al having a thickness of 90 nm and an Ag layer 42 having a thickness of 200 nm were successively deposited by a sputtering method. At this time, each of the connection grooves 905 was filled with the metal material constituting the back electrode layer.

Thereafter, by using the second harmonic of the YAG laser having an energy density of 0.6 J/cm², separation grooves 904 penetrating the front photoelectric conversion unit 2, the intermediate transmissive-reflective layer 6, the rear photoelectric conversion unit 3 and the back electrode layer 4 were formed.

After the formation of the separation grooves 904, by using pure water as cleaning medium, a five-minute ultrasonic washing with frequency of 38 kHz was carried out.

The thin-film photoelectric conversion device 901 of Example 1 thus obtained was irradiated with light of 1.5 AM (air mass) at a quantity of light of 100 mW/cm² so that its output characteristic was measured. The results are shown in Table 1.

### (Comparative Example 1)

In Comparative Example 1 of the invention, an integrated-type thin-film photoelectric conversion devise similar to that of Example 1 was produced. More specifically, the integrated-type thin-film photoelectric conversion devise of Comparative Example 1 was different from Example 1 only in that the formation of the transparent underlying layer 112 was omitted in the substrate with transparent electrode 1. The output characteristic of the resulting integrated-type thin-film photoelectric conversion device of Comparative Example 1 was measured in the same manner as in Example 1 to obtain the results shown in Table 1.

### (Summary of Example 1 and Comparative Example 1)

From the comparison of Comparative Example 1 with Example 1, it will be understood that when the substrate with transparent electrode layer 1 does not include the transparent underlying layer 112, all of Voc, Jsc and FF decrease, and Eff considerably decreases. In addition, in the Comparative Example 1 in which the substrate with transparent electrode layer 1 does not include the transparent underlying layer 112, detachment of the transparent electrode layer 12 starting from the separation groove 903 formed by laser scribing was observed at plural sites
Also,
From this fact, it has been confirmed that, when the transparent underlying layer 112 is absent, the adhesion of the transparent electrode layer 12 decreases. The reason why no detachment occurs in Example 1 may be the following two points. That is, the points are that the adhesion force between the transparent base member and the underlying layer is large and that the adhesion force between the transparent underlying layer and the transparent electrode layer is large. The adhesion force between the transparent base member and the underlying layer seems to be due to the bonding by a baking process of the binder and glass used as a material of the transparent underlying layer. Also, with respect to the adhesion force between the underlying layer and the transparent electrode layer, it seems that the surface area at the interface thereof increases due to the fine irregularities of the underlying layer at the interface, and that an anchor effect is generated by stacking the transparent electrode layer onto a recess of the underlying layer, whereby the detachment at the peripheries of separation groove 903 is suppressed in its formation.

### (Reference Example 1)

In Reference Example 1, an integrated-type thin-film photoelectric conversion devise similar to that of Example 1 was also produced. More specifically, the integrated-type thin-film photoelectric conversion devise of this Reference Example 1 was different from Example 1 only in that the laser scribing energy density utilized in the formation of separation grooves 904 was 0.7 J/cm². The output characteristic of the resulting integrated-type thin-film photoelectric conversion device of Reference Example 1 was measured in the same manner as in Example 1 to obtain the results shown in Table 1.

### (Comparative Example 2)

In Comparative Example 2, an integrated-type thin-film photoelectric conversion devise similar to that of Example 1 was also produced. More specifically, the integrated-type thin-film photoelectric conversion devise of Comparative Example 2 was different from Example 1 only in that the transparent base member utilized had a different content ratio. The content ratio of the transparent base member utilized in Comparative Example 2 is shown in Table 3.

**[Table 3]**

| SiO₂ | Fe₂O₃ | Al₂O₃ | CaO | MgO | K₂O | Na₂O | SO₃ |
|---|---|---|---|---|---|---|---|
| 71.7 | 0.025 | 1.74 | 8.5 | 4.2 | 0.7 | 13 | 0.12 |

The adhesion force of the insulating transparent substrate obtained in Comparative Example 2 was measured in the same manner as in Example 1. As a result, the adhesion force of the insulating transparent substrate obtained in Comparative Example 2 was 150 revolutions.

The output characteristic of the resulting integrated-type thin-film photoelectric conversion device of Comparative Example 2 was measured in the same manner as in Example 1 to obtain the results shown in Table 1.

### (Comparative Example 3)

In Comparative Example 3, an integrated-type thin-film photoelectric conversion devise similar to that of Example 1 was also produced. More specifically, the integrated-type thin-film photoelectric conversion devise of Comparative Example 3 was different from Example 1 in that a transparent base member, as utilized in Comparative Example 2, having a magnesium oxide content of more than 4.0 wt% was used, and in that the laser scribing energy density utilized in the formation of separation grooves 904 was 0.7 J/cm². The output characteristic of the resulting integrated-type thin-film photoelectric conversion device of Comparative Example 3 was measured in the same manner as in Example 1 to obtain the results shown in Table 1.

### (Summary of Example 1, Reference Example 1 and Comparative Examples 2-3)

From the comparison of Example 1 with Reference Example 1 and Comparative Example 3, it will be understood that, when the energy density of laser scribing used for forming the separation groove 904 is large, all of Voc, Jsc and FF decrease, whereby Eff is lowered. The reason therefor is not necessarily clear; however, it seems that, because the laser energy density used for forming the separation groove 904 was large, the transparent electrode layer was damaged and damages were given to the surroundings of the separation groove 904 when the laser passed through the transparent conductive layer. Similarly, it will be understood that, in Comparative Examples 2, 3 in which the damages to the transparent conductive layer and the scribe surroundings or the composition content ratio of the transparent base member is different, all of Voc, Jsc and FF decrease, whereby Eff is lowered. The reason therefor is not also clear; however, it seems that, because the adhesion force of the underlying layer is small, partial detachment by scribing occurred at the interface between the transparent base member and the underlying layer at the time of forming the separation groove 904.

### (Example 2)

In Example 2, an integrated-type thin-film photoelectric conversion devise similar to that of Example 1 was also produced. More specifically, the integrated-type thin-film photoelectric conversion devise of Example 2 was different from Example 1 only in that three times of five-minute, total time of 15 minutes, ultrasonic washing in the same manner as in Example 1 was carried out after the formation of the separation grooves 904. The output characteristic of the resulting integrated-type thin-film photoelectric conversion device of Example 2 was measured in the same manner as in Example 1 to obtain the results shown in Table 1.

### (Comparative Example 4)

In Comparative Example 4, an integrated-type thin-film photoelectric conversion devise similar to that of Example 2 was produced. More specifically, the integrated-type thin-film photoelectric conversion devise of Comparative Example 4 was different from Example 2 only in that a transparent base member, as utilized in Comparative Example 2, having a magnesium oxide content of more than 4.0 wt% was used. The output characteristic of the resulting integrated-type thin-film photoelectric conversion device of Comparative Example 4 was measured in the same manner as in Example 1 to obtain the results shown in Table 1.

### (Summary of Examples 1-2 and Comparative Example 4)

From the comparison between Example 1 and Example 2, it will be understood that, when the number of times of the washing is large, all of Voc, Jsc and FF are improved, whereby Eff is improved. The reason therefor seems to be that, according as the number of times of the washing increases, the residual stock removals on the separation groove 904 are removed to improve the properties. Also, when comparison is made between Example 2 and Comparative Example 4, when the adhesion force of the underlying layer is small, large improvement of properties was not seen even when the number of times of the washing is increased. The reason therefor is not necessarily clear; however, it seems that, according as the number of times of the washing increases, the effect of improvement of the properties due to removal of the residual stock removals of the separation groove 904 is cancelled by the decrease in the properties due to detachment of the underlying layer deriving from small adhesion force.

From the above, it will be understood that, when a transparent underlying layer is formed on a transparent base member having a specific composition, the adhesion between the two is improved, so that the detachment is hardly generated even when the residual stock removals at the time of laser scribing are washed under a comparatively severe condition and, as a result, an integrated-type thin-film photoelectric conversion device with improved properties is obtained.

### DESCRIPTION OF REFERENCE SIGNS

- 1, 1A: Substrate with transparent electrode
- 11, 11A: Transparent insulating base member
- 111:: Transparent base member
- 1111: Underlying surface
- 1112: Antireflection surface
- 112: Transparent underlying layer
- 1121: Transparent fine particle
- 1122: Transparent binder
- 113: Transparent antireflection layer
- 1131: Transparent fine p article
- 1132:: Transparent binder
- 12: Transparent electrode layer
- 2, 3: Photoelectric conversion unit
- 21, 31: One-conductivity-type layer
- 22, 32: Photoelectric conversion layer
- 23, 33: Opposite-conductivity-type layer
- 4: Back electrode layer
- 41: Conductive oxide layer
- 42: Metal layer
- 5: Thin-film photoelectric conversion device
- 6: Intermediate transmissive-reflective layer
- 901: Integrated-type thin-film photoelectric conversion device
- 902: Photoelectric conversion cell
- 903: First separation groove
- 904: Second separation groove
- 905: Connection groove

## Claims

1. A thin-film photoelectric conversion device (5), comprising: a substrate with transparent electrode layer; (1A) at least one photoelectric conversion unit (2,3), formed on the transparent electrode layer (12): and a back electrode layer (4),
the substrate with transparent electrode layer (1A) comprising: a transparent base members (111) and a transparent underlying layer (112) and a transparent electrode layer (12) both stacked in this order on an underlying surface (1111) that is one main surface of the transparent base member (111),
the transparent electrode layer (12) the photoelectric conversion unit (2,3) and the back electrode layer (4) are separated from one another by a plurality of groove (903, 904) so as to form a plurality of photoelectric conversion cells, (902), and the plurality of photoelectric conversion cells (902) are electrically connected to each other through a plurality of connection grooves (905),
the transparent underlying layen (112) comprises transparent insulating fine particles (1121) and transparent binder (1122), and
the transparent electrode layer (12) comprise zinc oxide deposited by a low-pressure CVD method, **characterised in that** the magnesium oxide content ratio in the transparent base member (111) is from 0.2 to 2.0wt%.

2. The thin-film photoelectric conversion device according to claim 1, wherein said at least one photoelectric conversion unit (2,3) comprises an amorphous photoelectric conversion unit.

3. The thin-film photoelectric conversion device according to claim 1 or 2, wherein said at least one photoelectric conversion unit (2,3) comprises a crystalline photoelectric conversion unit.

4. A method for producing a thin-film photoelectric conversion device (5) the thin-film photoelectric conversion device comprising: a substrate with transparent electrode layer (1A) at least one photoelectric conversion unit (2,3) formed on the transparent electrode layer (12) and a back electrode layer (4), the substrate with transparent electrode layer (1A) comprising: a transparent base member (111), and a transparent underlying layer (112) and a transparent electrode layer (12) both stacked in this order on an underlying surface (1111) that is one main surface of the transparent base member (111),
the method comprising steps of
preparing a base member having a magnesium oxide content ratio in the transparent base member (111) of from 0.2 to 2.0 wt%,
forming a transparent underlying layer (112) by using a coating solution including transparent insulating fine particles, (1121) and transparent binder (1122);
depositing a transparent electrode layer (12) including zinc oxide by low-pressure CVD method;
depositing a photoelectric conversion unit (2,3); and
depositing a back electrode layer (4),
wherein a plurality of back electrode separation grooves (903, 904) penetrating through the transparent electrode layer (12), the photoelectric conversion unit (2,3) and the back electrode layer (4) are formed by a laser scribing process.

5. The method for producing a thin-film photoelectric conversion device (5) according to claim 4, wherein at least one kind of washing selected from the group consisting of an ultrasonic washing, a high-pressure washing, and an alkali washing is carried out after the formation of the back electrode separation grooves.

6. The method for producing a thin-film photoelectric conversion device (5) according to claim 4 or 5, wherein a laser energy density for forming the back electrode separation grooves (903, 904) is set to from 0.95 to 1.05 times larger than the energy that allow the back electrode separation grooves to be formed.

7. The method for producing a thin-film photoelectric conversion device (5) according to any one of claims 4 to 6, wherein the photoelectric conversion unit (2,3) comprises a crystalline photoelectric conversion unit.

## Patentansprüche

1. Fotoelektrische Dünnfilm-Umwandlungsvorrichtung (5), umfassend: ein Substrat mit transparenter Elektrodenschicht (1A); mindestens eine fotoelektrische Umwandlungseinheit (2, 3), gebildet auf der transparenten Elektrodenschicht (12), und eine Rückelektrodenschicht (4),
worin das Substrat mit transparenter Elektrodenschicht (1A) umfasst: ein transparentes Basisbauteil (111), und eine transparente unterliegende Schicht (112) und eine transparente Elektrodenschicht (12), die beide in dieser Reihenfolge auf einer unterliegenden Oberfläche (1111) gestapelt sind, die eine Hauptoberfläche des transparenten Basisbauteils (111) ist,
worin die transparente Elektrodenschicht (12) der fotoelektrischen Umwandlungseinheit (2, 3) und die Rückelektrodenschicht (4) voneinander durch eine Vielzahl von Trenngräben (903, 904) so getrennt sind, das eine Vielzahl von fotoelektrischen Umwandlungszellen (902) gebildet sind, und worin die Vielzahl der fotoelektrischen Wandlungszellen (902) miteinander durch eine Vielzahl von Verbindungsgräben (905) elektrisch verbunden sind,
worin die transparente unterliegende Schicht (112) transparente isolierende Feinpartikel (1121) und ein transparentes Bindemittel (1122) umfasst, und
die transparente Elektrodenschicht (12) Zinkoxid umfasst, das durch ein CVD-Verfahren bei niedrigem Druck abgeschieden ist, **dadurch gekennzeichnet, dass** der Magnesiumoxid-Mengenanteil in dem transparenten Basisbauteil (111) von 0,2 bis 2,0 Gew.% beträgt.

2. Fotoelektrische Dünnfilm-Umwandlungsvorrichtung gemäß Anspruch 1, worin die zumindest eine fotoelektrische Umwandlungseinheit (2, 3) eine amorphe fotoelektrische Umwandlungseinheit umfasst.

3. Fotoelektrische Dünnfilm-Umwandlungsvorrichtung gemäß Anspruch 1 oder 2, worin die zumindest eine fotoelektrische Umwandlungseinheit (2, 3) eine kristalline fotoelektrische Umwandlungseinheit umfasst.

4. Verfahren zur Herstellung einer fotoelektrischen Dünnfilm-Umwandlungsvorrichtung (5), worin die fotoelektrische Dünnfilm-Umwandlungsvorrichtung umfasst: ein Substrat mit transparenter Elektrodenschicht (1A), mindestens eine fotoelektrische Umwandlungseinheit (2, 3), die auf der transparenten Elektrodenschicht (12) gebildet ist; und eine Rückelektrodenschicht (4), wobei das Substrat mit transparenter Elektrodenschicht (1A) umfasst: ein transparentes Basisbauteil (111); und eine transparente unterliegende Schicht (112) und eine transparente Elektrodenschicht (12), die beide in dieser Reihenfolge auf einer unterliegenden Oberfläche (1111) gestapelt sind, die eine Hauptoberfläche des transparenten Basisbauteils (111) ist,
wobei das Verfahren die Schritte umfasst:
Vorbereiten eines Basisbauteils mit einem Magnesiumoxid-Mengenanteil in dem transparenten Basisbauteil (111) von 0,2 bis 2,0 Gew.%;
Bilden einer transparenten unterliegenden Schicht (112) unter Verwendung einer Beschichtungslösung, die transparente isolierende Feinpartikel (1121) und ein transparentes Bindemittel (1122) umfasst;
Abscheiden einer transparenten Elektrodenschicht (12), die Zinkoxid enthält, durch ein CVD-Verfahren bei niedrigem Druck;
Abscheiden einer fotoelektrischen Umwandlungseinheit (2, 3); und
Abscheiden einer Rückelektrodenschicht (4),
worin eine Vielzahl von Rückelektroden-Trennungsgräben (903, 904), die durch die transparente Elektrodenschicht (12), die fotoelektrische Umwandlungseinheit (2, 3) und die Rückelektrodenschicht (4) penetrieren, durch einen Laser-Schreibe-Prozess gebildet werden.

5. Verfahren zur Herstellung einer fotoelektrischen Dünnfilm-Umwandlungsvorrichtung (5) gemäß Anspruch 4, worin mindestens eine Art von Waschung, ausgewählt aus der Gruppe, bestehend aus einer Ultraschallwaschung, einer Hochdruckwaschung und einer Alkaliwaschung, nach dem Bilden der Rückelektroden-Trenngräben durchgeführt wird.

6. Verfahren zur Herstellung einer fotoelektrischen Dünnfilm-Umwandlungsvorrichtung (5) gemäß Anspruch 4 oder 5, worin die Laserenergiedichte zum Bilden der Rückelektroden-Trenngräben (903, 904) zum 0,95- bis 1,05-fach größeren eingestellt wird als die Energie, die es ermöglicht, dass die Rückelektroden-Trenngräben gebildet werden.

7. Verfahren zur Herstellung einer fotoelektrischen Dünnfilm-Umwandlungsvorrichtung (5) gemäß irgendeinem der Ansprüche 4 bis 6, worin die fotoelektrische Umwandlungseinheit (2, 3) eine kristalline fotoelektrische Umwandlungseinheit umfasst.

## Revendications

1. Dispositif de conversion photoélectrique à couche mince (5) comprenant un substrat avec une couche d'électrode transparente (1A) ; au moins une unité de conversion photoélectrique (2, 3) formée sur la couche d'électrode transparente (12) et une couche d'électrode dorsale (4),
le susbstrat avec la couche d'électrode transparente (1A) comprenant un élément de base transparent (111) ; et une couche sous-jacente transparente (112) et une couche d'électrode transparente (12), toutes deux empilées dans cet ordre sur une surface sous-jacente (1111) qui est une surface principale de l'élément de base transparent (111),
la couche d'électrode transparente (12), l'unité de conversion photoélectrique (2, 3) et la couche d'électrode (4) étant séparées l'une de l'autre par une pluralité de rainures de séparation (903, 904) de manière à former une pluralité de cellules de conversion photoélectrique (902) et la pluralité de cellules de conversion photoélectrique (902) sont connectées électriquement l'une à l'autre par une pluralité de rainures de connexion (905),
la couche sous-jacente transparente (112) comprenant de fines particules isolantes transparentes (1121) et un liant transparent (1122) et
la couche d'électrode transparente (12) comprenant de l'oxyde de zinc déposé par un procédé CVD à basse pression, **caractérisé en ce que** le rapport de teneurs en oxyde de magnésium dans l'élément de base transparent (111) est de 0,2 à 2,0 % en poids.

2. Dispositif de conversion photoélectrique à couche mince selon la revendication 1, dans lequel ladite au moins une unité de conversion photoélectrique (2, 3) comprend une unité de conversion photoélectrique amorphe.

3. Dispositif de conversion photoélectrique à couche mince selon la revendication 1 ou 2, dans lequel ladite au moins une unité de conversion photoélectrique (2, 3) comprend une unité de conversion photoélectrique cristalline.

4. Procédé de production d'un dispositif de conversion photoélectrique à couche mince (5), le dispositif de conversion photoélectrique à couche mince comprenant : un substrat avec une couche d'électrode transparente (1A), au moins une unité de conversion photoélectrique (2, 3) formée sur la couche d'électrode transparente (12) et une couche d'électrode arrière (4), le susbstrat avec la couche d'électrode transparente (1A) comprenant un élément de base transparent (111) ; et une couche sous-jacente transparente (112) et une couche d'électrode transparente (12), toutes deux empilées dans cet ordre sur une surface sous-jacente (1111) qui est une surface principale de l'élément de base transparent (111),
le procédé comprenant les étapes consistant à :
préparer un élément de base ayant un rapport de teneurs en oxyde de magnésium dans l'élément de base transparent (111) de 0,2 à 2,0 % en poids,
former une couche sous-jacente transparente (112) en utilisant une solution de revêtement comprenant de fines particules isolantes transparentes (1121) et un liant transparent (1122) ;
déposer une couche d'électrode transparente (12) comprenant de l'oxyde de zinc par un procédé CVD à basse pression ;
déposer une unité de conversion photoélectrique (2, 3) ; et
déposer une couche d'électrode dorsale (4),
dans lequel une pluralité de rainures de séparation (903, 904) d'électrode dorsale pénétrant à travers la couche d'électrode transparente (12), l'unité de conversion photoélectrique (2, 3) et la couche d'électrode dorsale (4) sont formées par un processus de traçage au laser.

5. Procédé de production d'un dispositif de conversion photoélectrique à couche mince (5) selon la revendication 4, dans lequel au moins un type de lavage choisi dans le groupe constitué d'un lavage ultrasonique, d'un lavage à haute pression et d'un lavage par un alcali est effectué après la formation des rainures de séparation d'électrode dorsale.

6. Procédé de production d'un dispositif de conversion photoélectrique à couche mince (5) selon la revendication 4 ou 5, dans lequel la densité énergétique du laser pour former les rainures de séparation d'électrode dorsale (903, 904) est réglée à une valeur 0,95 à 1,05 fois plus grande que l'énergie qui permet de former les rainures de séparation d'électrode dorsale.

7. Procédé de production d'un dispositif de conversion photoélectrique à couche mince (5) selon l'une quelconque des revendications 4 à 6, dans lequel l'unité de conversion photoélectrique (2, 3) comprend une unité de conversion photoélectrique cristalline.
